Europäisches Patentamt

(19) European Patent Office

Office européen des brevets

(11) Publication number: 0 136 872
A2

## (12) EUROPEAN PATENT APPLICATION

(21) Application number: 84306459.3

(22) Date of filing: 21.09.84

(51) Int. Cl.⁴: **H 01 S 3/133**
**H 01 S 3/045**

(30) Priority: 01.10.83 GB 8326370

(43) Date of publication of application:
10.04.85 Bulletin 85/15

(84) Designated Contracting States:
AT BE CH DE FR IT LI LU NL SE

(71) Applicant: STANDARD TELEPHONES AND CABLES
PUBLIC LIMITED COMPANY
190 Strand
London, WC2R 1DU(GB)

(72) Inventor: Cooper, Peter Raymond
36, Meadway Freezywater
Enfield Middlesex(GB)

(72) Inventor: Shaw, Barry John
143 Long Ley
Harlow Essex(GB)

(74) Representative: Laurence, Simon French
STC Patent Department Edinburgh Way
Harlow Essex CM20 2SH(GB)

(54) Stabiliser optical source.

(57) A stabilised output optical source is provided which uses a germanium photodetector (6) as the sensor of a first feedback control circuit to monitor the output of a semiconductor laser (1) and control the laser drive (4). The sensitivity of the photodetector is in its turn stabilised by means of a second feedback control circuit controlling the drive (10) of a Peltier heat pump (8) to which the detector is attached. The sensor for this second feedback control circuit is a thermistor (9) also mounted on the heat pump.

EP 0 136 872 A2

Croydon Printing Company Ltd

## STABILISED OPTICAL SOURCE

This invention relates to a stabilised output optical source.

Stabilised output optical sources are required for a whole range of applications including, but not limited to, optical communications.  In the case of semiconductor injection diode light sources that are lasers operated as lasers, or lasers operated beneath threshold as led's, it has generally been found convenient to monitor light output by placing a photodetector in the path of emission from the rear facet of the laser.  Alternatively optical power can be tapped from the main output beam.  (This will also normally be the more convenient approach for other constructions of led.)  For some applications sufficient stability of the optical output is provided merely by using such a detector as the control element of a feedback path regulating the laser drive.  However, for other applications this regulation is not sufficient on its own because changes in ambient temperature produce changes in photodetector dark current that upset the regulation system.  Such temperature effects are particularly to be observed when the wavelength of emission is moved sufficiently far into the infra-red for it to be necessary to use a germanium photodetector rather than a silicon one.

According to the present invention there is provided a stabilised output optical source including an injection diode, a semiconductor photodetector for monitoring the optical output of the diode, and feedback controlled injection diode drive circuitry incorporating the photodetector as the control element of its feedback path, characterised in that the stabilised output optical source also includes a thermo-electric heat pump for cooling the photodetector, a temperature sensor for monitoring the photodetector temperature, and feedback controlled heat pump drive circuitry incorporating the temperature sensor as the control element of its feedback path.

The cooling of the photodetector reduces the masking effects of the dark current, while the temperature regulation stabilises the dark current so that changes of ambient temperature, at least over a restricted range, are unable to introduce spurious effects upsetting the stability of the optical output.

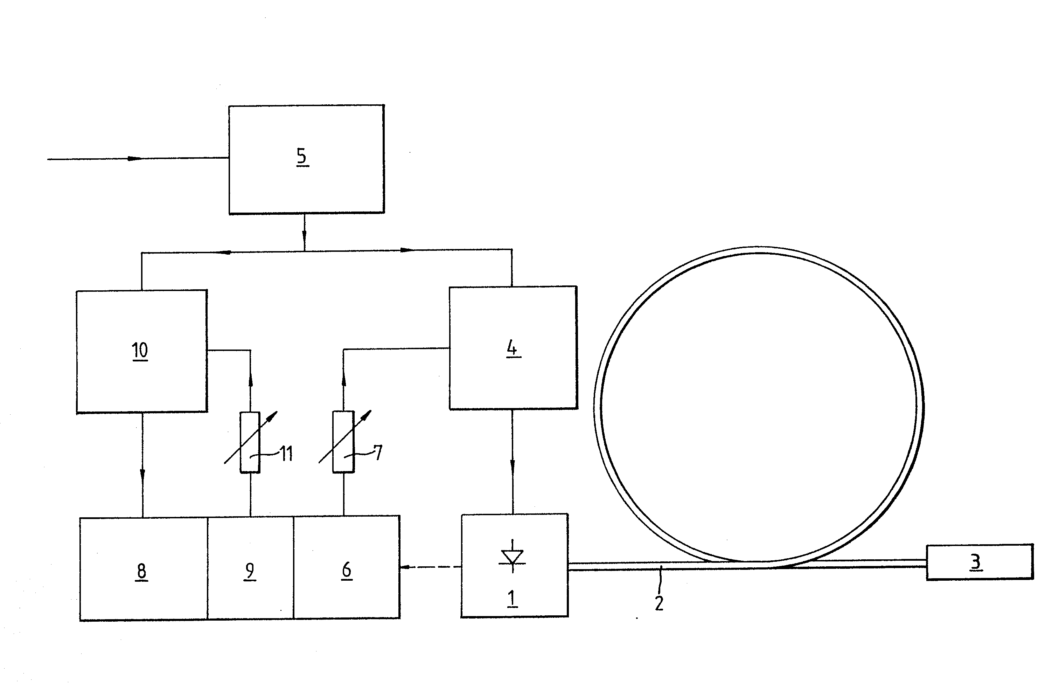

There follows a description of a stabilised optical source embodying the invention in a preferred form. The description refers to the accompanying drawing which schematically depicts the source.

This particular stabilised light source is designed for launching light into an optical fibre system. Light emission is provided by an (In,Ga)(As,P) laser 1 that in this instance is designed to operate at 1.3 microns at a drive level beneath lasing threshold. In order to ensure that the light fills all the modes of the system for which it is designed, the light from the laser 1 is directed into a length of about 20m of step index fibre 2 of larger core diameter and numerical aperture than the system fibre (not shown). The step index fibre 2 terminates in an optical fibre connector 3.

The power feed for the laser is from feedback-controlled drive circuitry 4 receiving power from a mains-fed stabilised power supply 5. The feedback control signal for regulating the laser drive circuitry 4 is provided by the output of a germanium photodetector 6.

The level of drive is manually adjustable, the adjustment means being represented by a potentiometer 7 in the feedback path. The laser drive circuitry 4 also includes means for protecting the laser from spikes, surges and overload, and is also provided with a warning lamp (not shown) to indicate when an overload condition is reached.

The germanium photodetector is mounted on the cold side of a thermo-electric Peltier heat pump 8 together with a thermistor 9. Power feed for the heat pump is from feedback-controlled drive circuitry 10 which also receives its power from the stabilised power supply 5. The feedback control signal for regulating the heat pump drive circuitry 10 is provided by the output of the thermistor 9. The level of drive is manually adjustable by means of a potentiometer 11 in series with the thermistor. The heat pump drive circuitry 10 also includes overload protection means together with a warning lamp (not shown) to indicate when an overload condition is reached.

In a particular instance, with a laser operated below lasing threshold as an led, the output stability measured at the connector end of the fibre 2 was $\pm$ 0.003 dB/$^{\mathrm{o}}$C over an ambient temperature range of $11^{\mathrm{o}}$-$30^{\mathrm{o}}$C, whereas with the heat pump disconnected the variation rose to 0.03 dB/$^{\mathrm{o}}$C over an ambient temperature range of $15^{\mathrm{o}}$-$30^{\mathrm{o}}$C.

CLAIMS :

1.    A stabilised output optical source including an injection diode, a semiconductor photodetector for monitoring the optical output of the diode, and feedback controlled injection diode drive circuitry incorporating the photodetector as the control element of its feedback path, characterised in that the stabilised output optical source also includes a thermo-electric heat pump for cooling the photodetector, a temperature sensor for monitoring the photodetector temperature, and feedback controlled heat pump drive circuitry incorporating the temperature sensor as the control element of its feedback path.

2.    An optical source as claimed in claim 1, wherein the injection diode is a laser.

3.    An optical source as claimed in claim 1 or 2, wherein the photodetector is a germanium photodetector.

4.    An optical source as claimed in claim 3, wherein the injection diode emission wavelength has a photon energy less than the band gap of silicon.